# EUROPÄISCHE PATENTSCHRIFT

(11) **EP 2 017 736 B1**
(45) Veröffentlichungstag und Bekanntmachung des Hinweises auf die Patenterteilung: **21.09.2011**
(21) Anmeldenummer: 08104222.8
(22) Anmeldetag: 02.06.2008
(51) Int. Cl.: G06F 12/02, G11C 16/10, G11C 16/22

(54) **Verfahren und Steuergerät zum Betreiben eines nichtflüchtigen Speichers, insbesondere zum Einsatz in Kraftfahrzeugen**
Method and control device for operating a non-volatile accumulator, in particular for use in motor vehicles
Procédé et appareil de commande destinés au fonctionnement d'une mémoire non volatile en particulier à utiliser dans des véhicules automobiles

(30) Priorität: 08.06.2007 DE 102007026690
(43) Veröffentlichungstag der Anmeldung: 21.01.2009
(73) Patentinhaber: ROBERT BOSCH GMBH, 70442 Stuttgart (DE)
(72) Erfinder: Boettcher, Joern, 74232 Abstatt (DE); Liebehenschel, Jens, 65835 Liederbach (DE); Schmid, Markus, 70182 Stuttgart (DE)

(56) Entgegenhaltungen:
- EP-A- 1 187 143
- US-A- 5 579 502

## Beschreibung

### Technisches Gebiet

Die Erfindung betrifft ein Verfahren und ein Steuergerät zum Betreiben von nichtflüchtigen Speichern, insbesondere Flash-Speichern, für den Einsatz z.B. im Automotiv-Bereich.

### Stand der Technik

Steuergeräte für den Automotiv-Bereich werden üblicherweise zur Steuerung und Überwachung von Funktionen des Fahrzeugmotors und/oder weiterer elektrischer Systeme im Kraftfahrzeug eingesetzt. Ein derartiges Steuergerät ist vorzugsweise mit einem nicht-flüchtigen Speicher ausgestattet, um verschiedene Betriebsgrößen und dgl. permanent, d.h. auch bei nicht anliegender Versorgungsspannung zu speichern, so dass das Steuergerät z.B. auch auf zurückliegende Daten zurückgreifen kann.

Die Anforderung an die im Automotiv-Bereich eingesetzten Komponenten sind jedoch sehr hoch, und es wird im allgemeinen eine sehr hohe Zuverlässigkeit während der gesamten Lebensdauer des Kraftfahrzeugs gefordert. An die in Automotiv-Steuergeräten eingesetzten nichtflüchtigen Speicher werden daher ebenfalls hohe Anforderungen gestellt. Üblicherweise werden als nichtflüchtige Speicher für Automotiv-Steuergeräte Flash-Speicher eingesetzt. Aufgrund von Degradationseffekten der Flash-Speicherzellen ist die Lebensdauer einer Flash-Speicherzelle auf eine bestimmte Anzahl von Schreibzyklen beschränkt. Herstellerseitig wird üblicherweise für einen Flash-Speicher eine bestimmte Anzahl von Schreibzyklen für eine bestimmte Gesamt-Betriebsdauer des Kraftfahrzeugs, während der das betreffende Steuergerät betrieben wird, gewährleistet.

Um die Häufigkeit, mit der in einem Steuergerät eine bestimmte Speicherzelle des nicht-flüchtigen Speichers überschrieben wird, zu reduzieren, wird die Größe des Speichers im Steuergerät erhöht und darin abzuspeichernde Betriebsgrößen in den Speicherbereich aufeinander folgend geschrieben. Dies erfordert die Implementierung eines Betriebsverfahrens, durch das die nächste freie, in Folge zu beschreibende Speicherposition in dem nicht-flüchtigen Speicher ermittelt wird, um anschließend dort die Betriebsgröße abzuspeichern.

Bislang wird ein solches Betriebsverfahren durchgeführt, indem in dem nichtflüchtigen Speicher die Betriebsgrößendaten in einem Datenabschnitt und in einem Verweisungsteil des nichtflüchtigen Speichers eine Adressinformation gespeichert wird, der eine Angabe zu einem entsprechenden Typ der Betriebsgrößendaten zugeordnet ist. Die Adressinformation gibt in der Regel eine Anfangsadresse des Datenbereichs an, in dem der in der Verweisungsteil angegebenen Typ der Betriebsgrößendaten gespeichert ist. Zum Ermitteln einer Schreib-Startadresse des mit weiteren Betriebsgrößendaten zu beschreibenden Datenbereichs in dem nicht-flüchtigen Speicher wird die Adressinformationen des zuletzt geschriebenen Datenbereichs aus dem Verweisungsteil identifiziert und die Startadresse des entsprechenden zuletzt geschriebenen Datenabschnitts ermittelt. Durch ein nachfolgendes Abrufen der Datenlänge der zuletzt gespeicherten Betriebsgrößendaten kann gemeinsam mit der Startadresse die Schreib-Startadresse ermittelt werden, d.h. die Adressposition, ab der der nichtflüchtige Speicher noch nicht beschrieben worden ist. Sowohl das Abrufen der Datenlängeninformation als auch das Berechnen der Schreib-Startadresse als Startadresse für die nachfolgend zu schreibenden Daten erfordert eine zusätzliche Kommunikation innerhalb des Steuergeräts und kann daher eine nicht vernachlässigbare Verarbeitungslast darstellen.

In der Druckschrift EP 1187143 sind ein Verfahren und eine Vorrichtung zum Speichern von Steuerdaten in einem nichtflüchtigen Speicher beschrieben. Dazu werden aufeinander folgende Speicherbereiche in einem nichtflüchtigen Speicher vorgesehen. Die Speicherbereiche sind markiert, um zu signalisieren, ob es sich um einen freien oder einen belegten Speicherbereich handelt, wobei die Markierung durch Schreiben eines Belegungsdatums an eine erste Position des jeweiligen Speicherbereichs erfolgt. Sollen neue Steuerdaten in den nichtflüchtigen Speicher geschrieben werden, so werden die einzelnen Speicherbereiche nacheinander ausgelesen, um festzustellen, ob das Belegungsdatum einen freien oder belegten Speicher signalisiert. Auf diese Weise wird der in aufsteigender Abfolge erste freie Speicherbereich festgestellt. Anschließend werden die Steuerdaten in den so bestimmten Speicherbereich geschrieben und das entsprechende Belegungsdatum entsprechend aktualisiert, so dass es nun anzeigt, dass der betreffende Speicherbereich belegt ist.

### Offenbarung der Erfindung

Es ist daher Aufgabe der vorliegenden Erfindung, ein Verfahren und ein Steuergerät zur Verfügung zu stellen, mit denen ein nicht-flüchtiger beschreibbarer Speicher in einfacher Weise betrieben werden kann.

Diese Aufgabe wird durch das Verfahren nach Anspruch 1 sowie durch das Steuergerät gemäß dem nebengeordneten Anspruch gelöst.

Weitere vorteilhafte Ausgestaltungen der Erfindung sind in den abhängigen Ansprüchen angegeben.

Gemäß einem ersten Aspekt ist ein Verfahren zum aufeinander folgenden Beschreiben eines nicht-flüchtigen Speichers mit Betriebsgrößendaten, insbesondere in einem Steuergerät in einem Kraftfahrzeug, vorgesehen. Das Verfahren umfasst die Schritte des Ermittelns einer Schreibadresse, die einen Adressbereich zum Schreiben eines zu schreibenden Betriebsgrößendatums definiert, wobei sich der Adressbereich unmittelbar an einen mit einem zuvor geschriebenen Betriebsgrößendatum belegten Speicherbereich anschließt, sowie des Schreibens des zu schreibenden Betriebsgrößendatums in den durch die Schreibadresse definierten Adressbereich des nicht-flüchtigen Speichers. Beim Schritt des Ermittelns entspricht die Schreibadresse einer den zuletzt geschriebenen Betriebsgrößendaten zugeordneten Adressinformation, die in einer Verweisungsinformation in dem nicht-flüchtigen Speicher gespeichert ist, direkt oder wird daraus mit Hilfe eines von der Größe der zuvor geschriebenen Betriebsgrößendaten unabhängigen Adressversatzes ermittelt.

Die vorgeschlagene Vorrichtung ermöglicht das Betreiben des Steuergeräts in verbesserter Weise, da das Feststellen des Adressbereichs zum nachfolgenden Beschreiben mit Betriebsgrößendaten ohne Verwendung einer Angabe einer Datenlänge der zuvor geschriebenen Betriebsgrößendaten durchgeführt werden kann. Es ist daher beim Schreibvorgang keine Verarbeitung bzw. Abrufen einer Datenlängeninformation notwendig, um den Adressbereich von nachfolgend zu schreibenden Daten zu bestimmen.

Weiterhin kann eine Verweisungsinformation geschrieben werden, die eine Adressinformation über die geschriebenen Betriebsgrößendaten angibt, die sich auf die letzte beschriebene Adresse des Adressbereichs bezieht.

Gemäß einer Ausführungsform kann die Adressinformation eine als letztes beschriebene Adressposition des Adressbereichs angeben, in den das Betriebsgrößendatum geschrieben worden ist.

Die Schreibadresse kann einer Schreib-Startadresse entsprechen, die einer Adressposition des Adressbereichs für ein erstes Datenbyte des zu schreibenden Betriebsgrößendatums entspricht.

Gemäß einem weiteren Aspekt ist ein Steuergerät, insbesondere zum Einsatz in einem Kraftfahrzeug, vorgesehen. Das Steuergerät umfasst eine Steuereinheit zum Bereitstellen von Betriebsgrößendaten und einen nicht-flüchtigen Speicher zum aufeinander folgenden Speichern der Betriebsgrößendaten. Die Steuereinheit ist ausgebildet, um eine Schreibadresse zu ermitteln, die einen Adressbereich zum Schreiben eines zu schreibenden Betriebsgrößendatums definiert, wobei sich der Adressbereich unmittelbar an einen mit einem zuvor geschriebenen Betriebsgrößendatum belegten Speicherbereich anschließt, und um das zu schreibende Betriebsgrößendatum in den durch die Schreibadresse definierten Adressbereich des nicht-flüchtigen Speichers zu schreiben. Beim Schritt des Ermittelns entspricht die Schreibadresse einer den zuletzt geschriebenen Betriebsgrößendaten zugeordneten Adressinformation, die in einer Verweisungsinformation in dem nicht-flüchtigen Speicher gespeichert ist, direkt, oder die Steuereinheit ist ausgebildet, um aus der Adressinformation mit Hilfe eines von der Größe der zuvor geschriebenen Betriebsgrößendaten unabhängigen Adressversatz zu ermitteln.

Weiterhin kann die Steuereinheit ausgebildet sein, um eine Verweisungsinformation zu schreiben, die eine Adressinformation über die geschriebenen Betriebsgrößendaten angibt, die sich auf die letzte beschriebene Adresse des Adressbereichs bezieht.

### Kurzbeschreibung der Zeichnungen

Bevorzugte Ausführungsformen der Erfindung werden nachfolgend anhand der beigefügten Zeichnungen näher erläutert. Es zeigen:
- Fig. 1: eine Blockdarstellung eines Steuergeräts mit einer Steuereinheit gemäß einer Ausführungsform der Erfindung;
- Fig. 2: eine veranschaulichende Darstellung der Datenstruktur in einem von der Steuereinheit verwendeten nicht-flüchtigen beschreibbaren Speicher.

### Beschreibung der bevorzugten Ausführungsformen

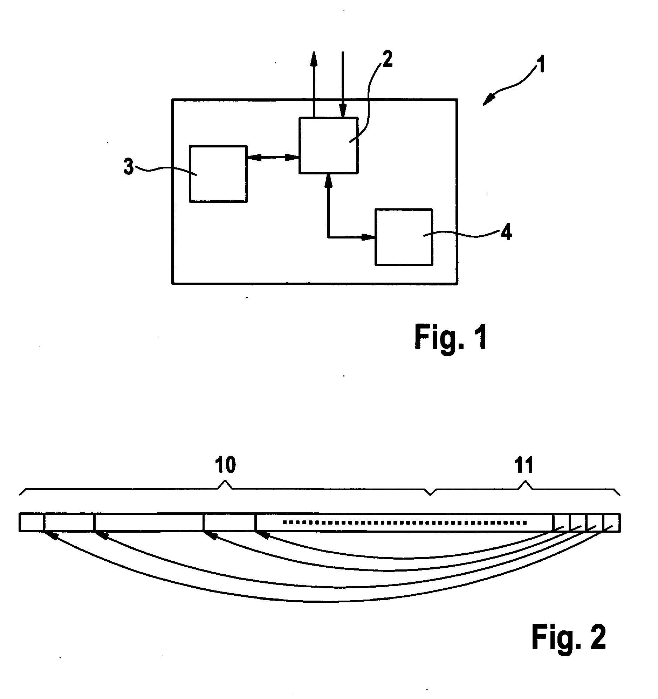

In Fig. 1 ist ein Steuergerät 1 z.B. für den Einsatz im Automotiv-Bereich dargestellt. Das Steuergerät 1 weist eine Steuereinheit 2 auf. Die Steuereinheit 2 führt Verfahren und Berechnungen durch, um eine Steuerung von Fahrzeugsystemen, wie z.B. die Motorsteuerung, die Steuerung weiterer elektrischer Systeme im Kraftfahrzeug und dgl. durchzuführen. Die Steuereinheit 2 ist mit einem Programm- und Festdatenspeicher 3 gekoppelt, in dem Programmbefehle zum Durchführen des von der Steuereinheit 2 ausgeführten Steuerverfahrens sowie unveränderliche Festdaten, wie z.B. Konstanten, Kennfelder und dergleichen gespeichert sind. Der Festdatenspeicher 3 ist vorzugsweise als nicht-flüchtiger, durch die Steuereinheit 2 im Normalbetrieb nicht beschreibbarer Speicher, wie z.B. ein ROM, Flash-Speicher, EPROM, EEPROM und dgl. ausgeführt.

Bei der Steuerung von Systemen durch die Steuereinheit 2 ist es häufig notwendig, Informationen über die zu steuernden Systeme, über Umfeldbedingungen und dergleichen als Betriebsgrößendaten zu erfassen, zu ermitteln und zu aktualisieren und die jeweils aktuellsten Betriebsgrößendaten permanent verfügbar zu halten, auch über einen Zeitraum hinweg, während dem das Steuergerät 1 für eine bestimmte Zeit ausgeschaltet ist, d.h. nicht mit einer Versorgungsspannung versorgt wird. Daten, die dann in einem etwaigen Arbeitsspeicher, wie z.B. einem flüchtigen Schreib-/Lesespeicher, z.B. einem RAM, gespeichert sind, gehen während einer solchen Zeitdauer verloren. Zum dauerhaften Speichern von Betriebsgrößendaten wird in der Regel ein nicht-flüchtiger, durch die Steuereinheit 2 beschreibbarer Speicher 4, z.B. in Form eines Flash-Speichers und dergleichen, vorgesehen, auf den die Steuereinheit 2 zugreifen kann, um bestimmte Betriebsgrößen zu speichern bzw. auszulesen.

Um die Belastung des nicht-flüchtigen Speichers 4 durch häufiges Beschreiben zu reduzieren, ist die Größe des nicht-flüchtigen Speichers 4 größer vorgesehen als für die Speicherung der Betriebsgrößen benötigt. Jedoch ist dazu ein Speichermanagement erforderlich. Im Detail werden zu speichernde Betriebsgrößendaten aufeinander folgend, d.h. der Reihe nach, in den Adressbereich des nicht-flüchtigen Speichers 4 geschrieben.

In Fig. 2 ist ein Beispiel eines nichtflüchtigen Speichers 4 schematisch dargestellt. Der Speicherbereich des Speichers 4 weist einen Datenbereich 10 und einen Verweisungsbereich 11 auf. Vorzugsweise befindet sich der Datenbereich an einem unteren Ende der logischen (oder physikalischen) Adressen des Speichers 4 und der Verweisungsbereich an einem oberen Ende der logischen (oder physikalischen) Adressen des Speichers 4. D.h. aufeinander folgende Betriebsgrößendaten werden zeitlich aufeinander folgend an fortlaufenden Adresspositionen gespeichert, während die jeweils zugeordneten Verweisungsdaten in dem Verweisungsbereich zeitlich nacheinander bei abnehmenden Adressen gespeichert werden. D.h. mit anderen Worten wird der nicht-flüchtige Speicher 4 von der einen Seite mit Daten und von der anderen Seite mit Verweisungsinformationen beschrieben.

Eine Verweisungsinformation enthält eine Angabe über den Typ der Betriebsgröße, die gespeichert werden soll, sowie eine Angabe über eine Adresse, womit die Position der zugeordneten Betriebsgröße in dem Speicherbereich des nichtflüchtigen Speichers 4 definiert wird. Beim Beschreiben des nicht-flüchtigen Speichers 4 durch die Steuereinheit 2 wird zunächst eine Schreib-Startadresse bestimmt, die den nächsten verfügbaren freien Speicherplatz (in Form einer Adresse) in dem nicht-flüchtigen Speicher 4 angibt. Anschließend werden Betriebsgrößendaten an die ermittelte Schreib-Startadresse geschrieben. Nach dem Schreiben der Betriebsgrößendaten wird in dem Verweisungsbereich 11 des nicht-flüchtigen Speichers eine entsprechende Verweisungsinformation an die zuletzt geschriebene Verweisungsinformation angehängt. In der Regel werden die Verweisungsinformationen in gleicher Weise wie die Betriebsgrößendaten aufeinander folgend gespeichert, jedoch in einem anderen Speicherbereich des nicht-flüchtigen Speichers.

Da die Betriebsgrößendaten aufeinander folgend, z.B. Byte-weise oder Wort-weise (oder in anderen Datenblöcken mit geringer Bitanzahl =< 32), in den Speicherbereich geschrieben werden, d.h. bezüglich ihrer logischen (oder physikalischen) Adressen aufeinander folgend, muss zum Schreiben der Betriebsgrößendaten durch die Steuereinheit 2 die Schreib-Startadresse ermittelt werden, bei der das Schreiben begonnen werden soll. Diese Adresse kann in besonders einfacher Weise bestimmt werden, wenn als Verweisungsinformation im Verweisungsbereich 11 die zuletzt geschriebene Verweisungsinformation ausgelesen wird und die dort angegebene Speicheradresse für die Ermittlung der Anfangsadresse verwendet werden kann, ohne dass eine Angabe über die Größe der zuvor geschriebenen Betriebsgrößendaten benötigt wird. D.h. im Gegensatz zu Systemen gemäß dem Stand der Technik, bei dem eine Anfangsadresse der zuvor geschriebenen Betriebsgrößendaten nebst einer Datenlänge benötigt wird, um die Schreib-Startadresse für ein Schreiben von zu schreibenden Betriebsgrößendaten zu ermitteln, ist es bei dem durch die Steuereinheit 2 durchgeführten Verfahren möglich, die Schreib-Startadresse für das Schreiben der neuen Betriebsgrößendaten ohne eine Angabe über die Datenlänge der Betriebsgrößendaten zu ermitteln.

Vorzugsweise gibt die Verweisungsinformation die zuletzt von den zuvor geschriebenen Betriebsgrößendaten geschriebene Speicheradresse an oder gleich die Schreib-Startadresse für den Speicherbereich, der als Nächstes beschrieben werden kann. In diesem Fall lässt sich die Position der zuvor beschriebenen Daten dennoch ermitteln, da der Datenbereich mit den Betriebsgrößendaten unmittelbar aufeinander folgend beschrieben wird, d.h. die Datensätze der Betriebsgrößendaten schließen sich unmittelbar aneinander an. Die Angabe einer Startadresse für das Schreiben von nächsten Betriebsgrößendaten ermöglicht es somit, in Kenntnis der Datenlänge der zuvor geschriebenen Betriebsgrößendaten deren Startadresse für ein eventuelles Auslesen zu ermitteln, da der der Schreib-Startadresse benachbarte Speicherbereich dem letzten Byte der zuvor geschriebenen Betriebsgrößendaten entspricht.

Das Verfahren zum Betrieben eines nicht-flüchtigen Speichers wird vorzugsweise durch die Steuereinheit 2 ausgeführt. Das Verfahren kann darin durch eine Hardware-Implementierung, einer Implementierung mit Hilfe einer Software, die einem Computerprogramm entspricht, sowie durch eine gemeinsame Implementierung durch Hardware und Software realisiert werden.

Im Allgemeinen wird also vorgeschlagen, in der Verweisungsinformation eine Adressinformation zu speichern, aus der sich ohne ein Abrufen oder Ermitteln der Datenlänge der zuvor beschriebenen Betriebsgrößendaten eine Schreib-Startadresse zum Schreiben der nächsten Betriebsgrößendaten ermitteln lässt. Trotzdem ist es mithilfe einer solchen Adressinformation möglich, in Kenntnis der Datenlänge der zuvor beschriebenen Betriebsgrößendaten die Startadresse der zuvor beschriebenen Betriebsgrößendaten zum Auslesen eindeutig zu ermitteln.

## Patentansprüche

1. Verfahren zum Beschreiben eines nicht-flüchtigen Speichers (4) mit Betriebsgrößendaten, insbesondere in einem Steuergerät (1) in einem Kraftfahrzeug,
wobei mehrere Betriebsgrößendaten aufeinanderfolgend geschrieben werden, wobei das Schreiben eines der Betriebsgrößendaten mit folgenden Schritten durchgeführt wird:
- Ermitteln einer Schreibadresse, die einen Adressbereich zum Schreiben des zu schreibenden Betriebsgrößendatums definiert, wobei sich der Adressbereich unmittelbar an einen mit dem zuletzt geschriebenen Betriebsgrößendatum belegten Adressbereich anschließt;
- Schreiben des zu schreibenden Betriebsgrößendatums in den durch die Schreibadresse definierten Adressbereich des nicht-flüchtigen Speichers (4);
- Schreiben einer Adressinformation über das geschriebene Betriebsgrößendatum in einen Verweisungsbereich (11) des nicht-flüchtigen Speichers;
wobei
beim Schritt des Ermittelns die Schreibadresse einer den zuletzt geschriebenen Betriebsgrößendaten zugeordneten Adressinformation direkt entspricht oder daraus mit Hilfe eines von der Größe der zuvor geschriebenen Betriebsgrößendaten unabhängigen Adressversatzes ermittelt wird.

2. Verfahren nach Anspruch 1, wobei eine Verweisungsinformation geschrieben wird, die eine Adressinformation über die geschriebenen Betriebsgrößendaten angibt, die sich auf die letzte beschriebene Adresse des Adressbereichs bezieht.

3. Verfahren nach Anspruch 1 oder 2, wobei die Adressinformation eine als letztes beschriebene Adressposition des Adressbereichs angibt, in den das Betriebsgrößendatum geschrieben worden ist.

4. Verfahren nach einem der Ansprüche 1 bis 3, wobei die Schreibadresse einer Schreib-Startadresse entspricht, die einer Adressposition des Adressbereichs für eine erste Dateneinheit, insbesondere ein erstes Datenbyte oder ein erstes Datenwort, des zu schreibenden Betriebsgrößendatums entspricht.

5. Steuergerät (1), insbesondere zum Einsatz in einem Kraftfahrzeug, umfassen:
- eine Steuereinheit (2) zum Bereitstellen von Betriebsgrößendaten;
- einen nicht-flüchtigen Speicher (4) zum aufeinander folgenden Speichern der Betriebsgrößendaten;
wobei die Steuereinheit (2) ausgebildet ist,
um zum Schreiben eines der Betriebsgrößendaten
- eine Schreibadresse zu ermitteln, die einen Adressbereich zum Schreiben des zu schreibenden Betriebsgrößendatums definiert, wobei sich der Adressbereich unmittelbar an einen mit dem zuletzt geschriebenen Betriebsgrößendatum belegten Adressbereich anschließt;
das zu schreibende Betriebsgrößendatum in den durch die Schreibadresse definierten Adressbereich des nicht-flüchtigen Speichers (4) zu schreiben; und
- eine Adressinformation über das geschriebene Betriebsgrößendatum in einen Verweisungsbereich (11) des nicht-flüchtigen Speichers zu schreiben;
wobei beim Schritt des Ermittelns die Schreibadresse einer den zuletzt geschriebenen Betriebsgrößendaten zugeordneten Adressinformation direkt entspricht, oder die Steuereinheit (2) ausgebildet ist, um daraus mit Hilfe eines von der Größe der zuvor geschriebenen Betriebsgrößendaten unabhängigen Adressversatzes zu ermitteln.

6. Steuergerät (1) nach Anspruch 5, wobei die Steuereinheit (2) ausgebildet ist, um eine Verweisungsinformation zu schreiben, die eine Adressinformation über die geschriebenen Betriebsgrößendaten angibt, die sich auf die letzte beschriebene Adresse des Adressbereichs bezieht.

7. Computerprogramm, das, wenn es auf einer Datenverarbeitungseinheit ausgeführt wird, ein Verfahren gemäß einem der Ansprüche 1 bis 4 ausführt.

## Claims

1. Method for operating a non-volatile memory (4) with operating variable data, in particular in a control device (1) in a motor vehicle, wherein a plurality of operating variable data are written successively, wherein the writing of one of the operating variable data is carried out by means of the following steps:
- determining a write address, which defines an address range for writing the operating variable datum to be written, wherein the address range directly follows an address range occupied by the operating variable datum written last;
- writing the operating variable datum to be written to that address range of the non-volatile memory (4); which is defined by the write address;
- writing an item of address information about the written operating variable datum to a reference area (11) of the non-volatile memory;
wherein
during the determining step, the write address corresponds directly to an item of address information assigned to the operating variable data written last or is determined therefrom with the aid of an address offset independent of the size of the operating variable data written previously.

2. Method according to Claim 1, wherein an item of reference information is written, which indicates an item of address information about the written operating variable data which refers to the last address written to in the address range.

3. Method according to Claim 1 or 2, wherein the address information indicates an address position written to last in the address range to which the operating variable datum has been written.

4. Method according to any of Claims 1 to 3, wherein the write address corresponds to a writing start address corresponding to an address position of the address range for a first data unit, in particular a first data byte or a first data word, of the operating variable datum to be written.

5. Control device (1) in particular for use in a motor vehicle, comprising:
- a control unit (2) for providing operating variable data;
- a non-volatile memory (4) for successively storing the operating variable data;
wherein the control (2) is designed,
for the purpose of writing one of the operating variable data,
- to determine a write address, which defines an address range for writing the operating variable datum to be written, wherein the address range directly follows an address range occupied by the operating variable datum written last;
to write the operating variable datum to be written to that address range of the non-volatile memory (4) defined by the write address; and
- to write an item of address information about the written operating variable datum to a reference area (11) of the non-volatile memory;
wherein
during the determining step, the write address corresponds directly to an item of address information assigned to the operating variable data written last or the control unit (2) is designed to determine therefrom with the aid of an address offset independent of the size of the operating variable data written previously.

6. Control device (1) according to Claim 5, wherein the control unit (2) is designed to write an item of reference information, which indicates an item of address information about the written operating variable data which refers to the last address written to in the address range.

7. Computer program which, if it is executed on a data processing unit, executes a method according to any of claims 1 to 4.

## Revendications

1. Procédé d'écriture de données de grandeurs opérationnelles dans une mémoire non volatile (4), notamment dans un contrôleur (1) dans un véhicule automobile, plusieurs données de grandeurs opérationnelles étant écrites successivement, l'écriture de l'une des données de grandeurs opérationnelles étant réalisée avec les étapes suivantes :
- détermination d'une adresse d'écriture qui définit une plage d'adresses pour écrire la donnée de grandeurs opérationnelles à écrire, la plage d'adresses étant directement rattachée à une plage d'adresses occupée par la donnée de grandeurs opérationnelles écrite en dernier ;
- écriture de la donnée de grandeurs opérationnelles à écrire dans la plage d'adresses de la mémoire non volatile (4) définie par l'adresse d'écriture ;
- écriture d'une information d'adresse sur la donnée de grandeurs opérationnelles écrite dans une zone de référencement (11) de la mémoire non volatile ; procédé selon lequel,
dans l'étape de détermination, l'adresse d'écriture correspond directement à une information d'adresse associée aux données de grandeurs opérationnelles écrites en dernier ou est déterminée à partir de celle-ci à l'aide d'un décalage d'adresse indépendant de la taille des données de grandeurs opérationnelles écrites précédemment.

2. Procédé selon la revendication 1, selon lequel une information de référencement est écrite, laquelle indique une information d'adresse sur les données de grandeurs opérationnelles écrites qui se rapporte à la dernière adresse écrite de la plage d'adresses.

3. Procédé selon la revendication 1 ou 2, selon lequel l'information d'adresse indique comme position d'adresse qui a été écrite en dernier de la plage d'adresses celle où a été écrite la donnée de grandeurs opérationnelles.

4. Procédé selon l'une des revendications 1 à 3, selon lequel l'adresse d'écriture est une adresse de début d'écriture qui correspond à une position d'adresse de la plage d'adresses pour une première unité de données, notamment un premier octet de données ou un premier mot de données, de la donnée de grandeurs opérationnelles à écrire.

5. Contrôleur (1), notamment destiné à être utilisé dans un véhicule automobile, comprenant :
- une unité de commande (2) pour délivrer des données de grandeurs opérationnelles ;
- une mémoire non volatile (4) pour l'enregistrement successif des données de grandeurs opérationnelles ; dans lequel l'unité de commande (2) est configurée
- pour écrire l'une des données de grandeurs opérationnelles ;
- pour déterminer une adresse d'écriture qui définit une plage d'adresses pour écrire la donnée de grandeurs opérationnelles à écrire, la plage d'adresses étant directement rattachée à une plage d'adresses occupée par la donnée de grandeurs opérationnelles écrite en dernier ;
- pour écrire la donnée de grandeurs opérationnelles à écrire dans la plage d'adresses de la mémoire non volatile (4) définie par l'adresse d'écriture ; et
- pour écrire une information d'adresse sur la donnée de grandeurs opérationnelles écrite dans une zone de référencement (11) de la mémoire non volatile ; dans lequel, dans l'étape de détermination, l'adresse d'écriture correspond directement à une information d'adresse associée aux données de grandeurs opérationnelles écrites en dernier ou alors l'unité de commande (2) est configurée pour effectuer la détermination à partir de celle-ci à l'aide d'un décalage d'adresse indépendant de la taille des données de grandeurs opérationnelles écrites précédemment.

6. Contrôleur (1) selon la revendication 5, dans lequel l'unité de commande (2) est configurée pour écrire une information de référencement, laquelle indique une information d'adresse sur les données de grandeurs opérationnelles écrites qui se rapporte à la dernière adresse écrite de la plage d'adresses.

7. Programme informatique qui, lorsqu'il est exécuté sur une unité de traitement de données, met en oeuvre un procédé selon l'une des revendications 1 à 4.
